# EUROPÄISCHE PATENTSCHRIFT

(11) **EP 3 161 496 B1**
(45) Veröffentlichungstag und Bekanntmachung des Hinweises auf die Patenterteilung: **02.09.2020**
(21) Anmeldenummer: 15733434.3
(22) Anmeldetag: 30.06.2015
(51) Int. Cl.: G01R 31/34, H02P 29/02, G01R 19/165, H02M 1/32, H02P 29/024

(54) **VERFAHREN ZUR ERLANGUNG EINES HINWEISES, INSBESONDERE EINES ANFANGSHINWEISES AUF EINE MÖGLICHE FEHLERHAFTE LASTBEDINGUNG EINES MEHRPHASIGEN ELEKTROMOTORS**
METHOD FOR OBTAINING AN INDICATION, IN PARTICULAR A STARTING INDICATION OF A POSSIBLE FAULTY LOAD CONDITION OF A MULTI-PHASE ELECTRIC MOTOR
PROCÉDÉ D'ACQUISITION D'UN RENSEIGNEMENT, EN PARTICULIER D'UN RENSEIGNEMENT INITIAL SUR UNE CONDITION DE CHARGE POTENTIELLEMENT INCORRECTE D'UN MOTEUR ÉLECTRIQUE À PLUSIEURS PHASES

(30) Priorität: 30.06.2014 DE 102014212572; 30.06.2014 DE 102014212586; 30.06.2014 DE 102014212626
(43) Veröffentlichungstag der Anmeldung: 03.05.2017
(60) Teilanmeldung: 18186091.7
(73) Patentinhaber: Elmos Semiconductor Aktiengesellschaft, 44227 Dortmund (DE)
(72) Erfinder: HARTZSCH, Jörg, 44227 Dortmund (DE)
(74) Vertreter: dompatent von Kreisler Selting Werner - Partnerschaft von Patent- und Rechtsanwälten mbB
(86) Internationale Anmeldenummer: PCT/EP2015/064786
(87) Internationale Veröffentlichungsnummer: WO 2016/001194

(56) Entgegenhaltungen:
- EP-A2- 1 136 828
- DE-A1-102008 052 933
- DE-A1-102011 003 897
- DE-A1-102011 004 911
- JOHNSON J P ET AL: "Review of sensorless methods for brushless DC", CONFERENCE RECORD OF THE 1999 IEEE INDUSTRY APPLICATIONS CONFERENCE. THIRTY-FORTH IAS ANNUAL MEETING (CAT. NO.99CH36370), IEEE, IEEE PISCATAWAY, NJ, USA, Bd. 1, 3. Oktober 1999 (1999-10-03), Seiten 143-150, XP010355155, DOI: 10.1109/IAS.1999.799944 ISBN: 978-0-7803-5589-7

## Beschreibung

Die Erfindung betrifft ein Verfahren zur Erlangung eines Hinweises, insbesondere eines Anfangshinweises auf eine mögliche fehlerhafte Lastbedingung eines mehrphasigen Elektromotors.

Fehlerhafte Lastbedingungen bei Elektromotoren sind insbesondere dann kritisch, wenn Kurzschlüsse auftreten. Derartige Kurzschlüsse werden üblicherweise anhand der Spannungsabfälle über den Drain-Source-Strecken der internen oder externen Treiber-Transistoren der Ansteuereinheit erkannt, über die Elektromotoren oder andere Lasten angesteuert werden. Diese Spannungsabfälle werden im Regelfall einzeln, d.h. pro Phase des Motors, bewertet. Wenn ein messtechnisch erfasster Strom höher als der größte in Betrieb zulässige Strom ist, deutet dies auf einen externen Kurzschluss von mindestens einer der Motoranschlussleitungen hin. Ein Nachteil bei der Detektion von Kurzschlüssen ist, dass insbesondere "weiche" Kurzschlüsse nach Masse nicht unbedingt erkannt werden können. Ein weiteres Problem besteht darin, dass der Überstrom bei relativ hochohmigen Kurzschlüssen oder bei Kurzschlüssen mit induktivem Beiwert des Kurzschlussstroms teilweise nicht außerhalb des größten, im Betrieb des Motors zulässigen Stroms liegt. Auch ist es bei induktiven Beiwerten und bei PWM-Ansteuerungen von Lasten, wie z.B. Elektromotoren, möglich, dass die Stromzunahme im Kurzschlussfall so langsam ist ("weicher" Kurzschluss), dass ein PWM-Zyklus vor Erreichen der Überstrom-Abschaltschwelle beendet ist. Die Leistungstransistoren aber können sich in derartigen Fällen dennoch derart stark aufheizen, dass es zu Schädigungen kommen kann, die so schnell auftreten, dass auch eine Übertemperaturerkennung wegen ihres Zeitverzuges keinen ausreichenden Schutz bietet.

Aus DE-A-10 2011 004 911, DE-B-10 2004 009 046, DE-A-102 36 377 und US-A-5 266 891 sind Verfahren zum Erkennen fehlerhafter Lastbedingungen bei mehrphasig geschalteten Elektromotoren bekannt, wobei jeweils der zeitliche Verlauf der Phasenströme ausgewertet wird.

Aufgabe der Erfindung ist es daher, eine Kurzschlusserkennung zu schaffen, die in der Lage ist, einen Kurzschluss zuverlässig aufzudecken und somit die Transistoren vor einer Schädigung zu schützen, was darauf hinausläuft, dass ein Brand der Elektronik verhindert werden kann.

Zur Lösung dieser Aufgabe wird mit der Erfindung ein Verfahren nach Anspruch 1 vorgeschlagen. Einzelne Ausgestaltungen der Erfindung sind Gegenstand der Unteransprüche 2 bis 13.

Das Verfahren nach der Erfindung dient der Erlangung eines Hinweises, insbesondere eines Anfangshinweises auf eine mögliche fehlerhafte Lastbedingung einer mehrphasig geschalteten induktiven Last mit elektronischer Kommutierung, insbesondere eines dreiphasigen Elektromotors mit elektrischer Kommutierung (z.B. BLDC-, EC-, SR-, Steppermotoren) mit einer Ansteuereinheit, die pro Motorphase einen Highside-Schalter und einen Lowside-Schalter aufweist, wobei die Highside- und Lowside-Schalter der Motorphasen zyklisch geschaltet werden, und zwar gemäß einem Schaltschema, das Zeitpunkte generiert, zu denen der Strom in einer Motorphase einen Nulldurchgang erfährt, der bedingt durch den induktiven Lastanteil, zeitlich versetzt zu demjenigen Zeitpunkt des Nulldurchganges ist, der bei rein ohmschen Lasten auftreten würde, wobei ohne fehlerhafte Lastbedingung der Zeitpunkt dieses Nulldurchganges in einem Erwartungswertbereich (z.B. Erwartungszeitfenster) erfolgt, welcher vom Schaltschema, den Umgebungsbedingungen (wie z.B. Versorgungsspannung und Temperatur) und von diversen Motorparametern (,zu denen auch Motorasymmetrien gehören können,) bestimmt wird, wobei mit bestehender fehlerhafter Lastbedingung der Zeitpunkt dieses Nulldurchganges außerhalb des Erwartungswertbereichs erfolgt, wobei anhand der Abweichung vom Erwartungswertbereich Rückschluss auf die Art der fehlerhaften Lastbedingung geschlossen werden kann, wobei das Verfahren die Schritte des Anspruchs 1 aufweist. Einzelne Ausgestaltungen der Erfindung sind Gegenstand der Unteransprüche.

Nach der Erfindung erfolgt die elektrische Kommutierung des Elektromotors mit Hilfe eines Schaltschemas, in dem zu gewissen Zeitpunkten pro Motorphase der Phasenstrom einen Nulldurchgang erfährt. Der Zeitpunkt dieses Nulldurchgangs eines Phasenstroms liegt zeitlich versetzt zu demjenigen Zeitpunkt, der bei rein ohmschen Lasten auftreten würde. Ohne fehlerhafte Lastbedingung befindet sich der Zeitpunkt dieses Nulldurchgangs innerhalb eines Erwartungswertbereichs (z.B. Erwartungszeitfenster), welcher vom Schaltschema, den Umgebungsbedingungen und von diversen Motorparametern bestimmt sein kann. Liegt der Nulldurchgang außerhalb des Erwartungswertbereichs, so kann dies als Anzeichen für eine fehlerhafte Lastbedingung betrachtet werden. Durch Beobachtung, ob, und wenn ja, inwieweit die erwarteten Nulldurchgangszeitpunkte von den Erwartungswertbereichen abweichen bzw. innerhalb dieser liegen, können dann Rückschlüsse auf mögliche Fehlerquellen des Motors gebildet werden. In jedem Fall sind Abweichungen der Größe der gemessenen Zeitspannen der einzelnen Motorphasen untereinander und/oder für jede einzelne Motorphase in sequentieller Abfolge von vorgebbaren Erwartungswertbereichen ein Hinweis, insbesondere ein Anfangshinweis für eine fehlerhafte Lastbedingung. Wie mit einem derartigen Anfangshinweis in der Folge umgegangen wird, ist nicht mehr Gegenstand der Erfindung. Die Verarbeitung derartiger Anfangshinweise kann applikationsbedingt unterschiedlich erfolgen. Beispielsweise ist es möglich, zunächst Anfangshinweise zu beobachten, um erst mit einer gewissen zeitlichen Verzögerung zu reagieren. Die Reaktion kann ebenfalls applikationsbedingt recht unterschiedlich sein. So kann beispielsweise der Motor abgeschaltet oder zum Schutz vor Beschädigungen in einen anderen Betriebsmodus überführt werden.

Zwecks Klassifizieren der Abweichung des betreffenden Parameters von dem entsprechenden Erwartungswert oder -bereich können Verfahren zur statistischen Mustererkennung Anwendung finden, mit denen Betriebszustände des elektrischen (Schritt-)Motors klassifizierbar sind, um definierte Maßnahmen zur Minimierung der Auswirkung von Fehlfunktionen und zur Prognostizierung der zukünftigen Auswirkungen einer Fehlfunktion auf den Motor ergreifen zu können. Die Prognose kann dabei in Form zukünftiger möglicher Betriebszustände erfolgen, denen Wahrscheinlichkeiten und/oder Bewertungszahlen (z.B. Auswirkungsbewertungen) zugeordnet sind.

Hierbei können ein oder mehrere der nachfolgend aufgelisteten Verarbeitungsschritte durchgeführt werden:
a) Bilden eines Feature-Vektors aus mehreren Werten der Abweichungen, die gleichzeitig und/oder sequenziell festgestellt werden wobei der Feature-Vektor einfache und höhere Ableitungen und/oder einfache und höhere Integrale dieser Werte und/oder andere aus diesen Werten abgeleitete Größen sowie weitere Größen aus anderen Sensorsystemen umfassen kann.
b) Multiplikation eines Feature-Vektors mit einer Lineardiskriminanzanalyse-(LDA-)Matrix zu einem modifizierten Feature-Vektor zur Steigerung der Selektivität.
c) Vergleich des modifizierten Feature-Vektors mit prototypischen Vektoren, d.h. den Betriebszustandsprototypen, die insbesondere in einer Prototypendatenbank abgelegt sind, wobei das Ergebnis des Vergleiches ein binärer und/oder digitaler und/oder analoger Abstandswert zwischen dem modifizierten Feature-Vektor und dem jeweiligen prototypischen Vektor je bewertetem prototypischen Vektor ist.
d) Selektion mindestens eines Betriebszustandsprototyps der besagten Datenbank aufgrund eines Abstandswertes, wobei insbesondere der Betriebszustandsprototyp mit dem kleinsten Abstandswert und/oder der Betriebszustand mit der schwersten Auswirkung und/oder mit der schwersten Auswirkungsbewertung selektiert wird.
e) Ausgabe zumindest des selektierten Betriebszustandsprototypen.
f) Gegebenenfalls Ausgabe zumindest des Abstandswertes der dem Feature-Vektor relativ zum selektierten Betriebszustandsprototypen zugeordnet ist und/oder eines daraus abgeleiteten Wertes.
g) Gegebenenfalls Ausgabe weiterer selektierter Betriebszustandsprototypen und zugehöriger Abstandswerte und/oder daraus abgeleiteter Werte zur Ausgabe einer Hypothesenliste, die typischerweise auch den selektierten Betriebszustandsprototypen und dessen Abstandswert umfasst.
h) Gegebenenfalls Ermittlung der wahrscheinlichsten Kette von Betriebszustandsprototypen und Prognose mindestens eines folgenden prognostizierten Betriebszustandes oder einer prognostizierten Betriebszustandssequenz.
i) Gegebenenfalls Einleitung von Maßnahmen auf Grund des selektierten Betriebszustandes und/oder der ermittelten Hypothesenliste und/oder des prognostizierten Betriebszustandes oder der prognostizierten Betriebszustandssequenz.

Alternativ zu den an sich bekannten Grundverfahren der statistischen Mustererkennung können zur Verarbeitung der Abweichungen des betreffenden Parameters von dem diesem zugeordneten Erwartungswert oder -bereich neuronale Netze und/oder Petrinetze und/oder Fuzzy-Logik und/oder ein Viterbi-Algorithmus eingesetzt werden.

Die Erwartungswerte bzw. Erwartungswertbereiche werden zweckmäßigerweise empirisch festgelegt. Hierbei ist denkbar,
- dass die Erwartungswerte für maximal zulässige Abweichungen, bei denen noch keine fehlerhafte Lastbedingung erkannt werden soll, an einem oder mehreren vorgealterten Referenzsystemen mit fehlerfreiem Lastzustand angelernt, also die typischen Werte ermittelt und mit wählbaren zusätzlichen zulässigen Toleranzen versehen in der Ansteuereinheit als maximal zulässiger Erwartungswertbereich abgelegt werden, und/oder
- dass die Erwartungswerte für maximal zulässige Abweichungen bei denen noch keine fehlerhafte Lastbedingung erkannt werden soll, an jedem Motorsystem für sich nach der Produktion mit fehlerfreiem Lastzustand angelernt , also die typischen Werte ermittelt und mit wählbaren zusätzlichen zulässigen Toleranzen versehen in der Ansteuereinheit als maximal zulässiger Erwartungswertbereich abgelegt werden, und/oder
- dass die Erwartungswerte für maximal zulässige Abweichungen bei denen noch keine fehlerhafte Lastbedingung erkannt werden soll, im Laufe der Lebenszeit des Motors mit höheren Toleranzen versehen werden, und/oder
- dass die detektierte fehlerhafte Lastbedingung durch ein Abweichen des Kommutierungswinkels vom Zielbereich entsteht und dass die Ansteuereinheit den Fehler durch Anpassung zumindest eines der beiden Ansteuerparameter Amplitude und Phase kompensiert.

In vorteilhafter Weiterbildung der Erfindung kann vorgesehen sein, dass aus der Art der Abweichungen von den Erwartungswertbereichen für die einzelnen Motorphasen untereinander auf die Art der fehlerhaften Lastbedingung wie Nebenschluss Motorphase gegen Motorphase, Nebenschluss Motorphase gegen Ground, Nebenschluss Motorphase gegen Versorgungsspannung, zu hochohmiger Motorphasenanschluss (evtl. durch Kontaktierungsproblem in Steckern), Wackelkontakt einer Motorphase, fehlerhafte Treiberwiderstände einzelner Highside- oder Lowside-Treiber (ggf. nur unter bestimmten Lastzuständen) und/oder auch für jede einzelne Motorphase in sequentieller Abfolge auf die fehlerhaften Lastbedingungen wie Wackelkontakt, mechanischer Fehler, Lagerspiel, Getriebefehler, mechanische Fehler in der Applikation geschlossen wird, wobei die Häufigkeit der sequentiell auftretenden Abweichungen Aussage geben kann über den genauen Fehlerort.

In vorteilhafter Weiterbildung der Erfindung kann ferner vorgesehen sein, dass anstelle der Größe eines Stroms ein die Größe des Stroms repräsentierender elektrischer Parameter gemessen wird, und zwar z.B. ein Spannungsabfall über einem elektrischen/elektronischen Bauteil, insbesondere über einem Shunt-Widerstand oder einem Transistor, bei dem es sich insbesondere um einen Highside- und/oder einen Lowside-Schalter handelt.

Ferner kann es zweckmäßig sein, wenn als Stromschwellwert ein Wert ungleich Null des Stroms gewählt wird.

Von Vorteil kann es sein, wenn als Stromschwellwert ein Wert in der Nähe des Nulldurchgangs gewählt wird.

Vorteilhaft kann es sein, wenn die Zeitspanne mittels eines linearen Zeitmessglieds mit konstanter Zählgeschwindigkeit gemessen wird.

Ferner kann es von Vorteil sein, wenn die Zeitspanne mittels eines logarithmischen Zeitmessglieds mit mit zunehmender Messzeit ansteigender Zählgeschwindigkeit gemessen wird.

In vorteilhafter Weiterbildung der Erfindung kann ferner vorgesehen sein, dass anstelle der beschriebenen exakten Zeitmessung lediglich zu einem festen Zeitpunkt nach auf Schaltung des Highside- und/oder Lowside-Treibers eine Überprüfung auf Über- oder Unterschreitung der vorgebbaren Stromschwelle erfolgt und demzufolge die Zeitmessung in der dadurch entstehenden Auflösung (Anzahl von PWM-Zyklen) erfolgt.

Vorteilhaft kann es sein, wenn anstelle der Zeitspanne zwischen dem besagten Zeitpunkt des Schaltschemas und der Einnahme des Stromschwellwerts diejenige Zeitspanne gemessen wird, bis der Strom bei der nächsten Motorphasenaufschaltung wieder den Stromschwellwert erreicht, und dass diese Zeitspannen der einzelnen Motorphasen untereinander und/oder jeder Motorphase für sich in zeitlicher Abfolge verglichen oder mit einem für den fehlerfreien Betrieb des Motors geltenden Erwartungswert verglichen werden, wobei eine Abweichung der Größe der aktuellen Zeitspannen untereinander und/oder von dem Erwartungswert als ein Hinweis, insbesondere Anfangshinweis auf einen Fehlerstrom gewertet wird.

Die Erfindung ist insbesondere vor dem Hintergrund zu sehen, dass für die Ansteuerung mehrphasiger Elektromotoren oder anderer induktiver Lasten in zunehmendem Maße niederohmige Leistungstransistoren eingesetzt werden. Diese Leistungstransistoren sind derart preisgünstig herstellbar, dass ihre Gesamtkosten für das Gesamtsystem geringer sind, als wenn man z.B. mit einem Kühlkörper zur Kühlung konventioneller Leistungstreiber arbeiten würde, die einen höheren R_{SDON} aufweisen. Ein weiterer Vorteil des Einsatzes moderner niederohmiger Leistungstransistoren ist in dem vereinfachten Verbau der Elektronik auf Grund der geringeren Verlustleistung dieser Leistungstransistoren zu sehen. Außerdem reduziert sich in der Gesamtenergiebilanz betrachtet der CO₂-Ausstoß. Allerdings sind durch die niederohmigen Leistungstransistoren die Spannungsabfälle im Kurzschlussfall wegen des niedrigen R_{SDON} derart klein, dass ein Kurzschlussfall mit bisherigen Mitteln nicht mehr sicher detektiert werden kann. Man arbeitet daher mit deutlich empfindlicheren Kurzschlussschwellen, um den geänderten Anforderungen infolge niederohmiger Leistungstransistoren begegnen zu können. Hierbei handelt es sich allerdings um Lösungen des Problems, die nicht alle Kurzschlussfälle zu erkennen vermögen. Insbesondere im Hinblick auf BLDC- und DC-Brückentreiber-ICs sowie Steppermotor-Treiber-ICs hat der erfindungsgemäße Ansatz klare Vorteile, indem er sich auf Grund der großen Nachfrage derartiger Treiber-ICs schnell durchsetzen würde.

Die Erfindung wird nachfolgend anhand eines Ausführungsbeispiels sowie unter Bezugnahme auf die Zeichnung näher erläutert. Im Einzelnen zeigen dabei:
- Fig. 1: eine Beschaltungsoption für einen grundsätzlich beliebig ausgestalteten dreiphasigen Elektromotor und
- Fig. 2: ausschnittsweise eine Sinus- oder Space-Vector-Kommutierung im Bereich des Vorzeichenwechsels des Stroms durch einen Treiber.

Der Erfindung liegt die Erkenntnis zu Grunde, dass beim Treiben von induktiven Lasten wie bei Elektromotoren mittels eines Komparators ermittelt wird, ob ein Transistor im eingeschalteten Zustand einen positiven Spannungsabfall (bei Last) oder einen negativen Spannungsabfall (bei induktiver Rückspeisung) aufweist.

Dies ist ein Zeichen für die Richtung des Stromflusses durch diesen Treiber (Schalter). Bei induktiven Lasten wie Motoren wird der Zeitpunkt der Stromrichtungsumkehr natürlich einerseits durch die Modulation der Ansteuerung des Motors bestimmt, andererseits aber auch durch das Verhalten des Spulenstroms, der der modulierten Spannung bekanntlich nacheilt. Der Erwartungswert, wann ein Wechsel von positivem zu negativem Spannungsabfall stattfinden sollte, der Strom durch den entsprechenden Treiber also auf Null abgesunken ist, ist durch die PWM-Modulation des Motors und die Motorparameter vorgegeben.

Weicht nun die Stelle des Vorzeichenwechsels eines Anschlusses (Motorphase) von der der anderen Anschlüsse (Motorphasen) oder auch von vorgegebenen Erwartungswerten reproduzierbar ab, so ist von einem Fehlerfall im Motor oder den Anschlüssen auszugehen, insbesondere dann, wenn sich die einzelnen Motorphasen bei der zeitlichen Betrachtung dieser Vorzeichenwechsel voneinander atypisch unterscheiden. Die Art der Abweichung ist ein Zeichen dafür, ob und an welchem Anschluss welche Art von Kurzschluss (Nebenschluss nach Masse oder zum positiven Versorgungspotential) oder Hochohmigkeit einer Verbindung vorliegt.

Es kann im Einzelfall ausreichend sein, lediglich die Lowside- oder lediglich die Highside-Treiber wie dargelegt zu überwachen. Bei entsprechender Empfindlichkeit der Messeinrichtung können die oben beschriebenen Signale auch zur Kommutierung des Motors genutzt werden.

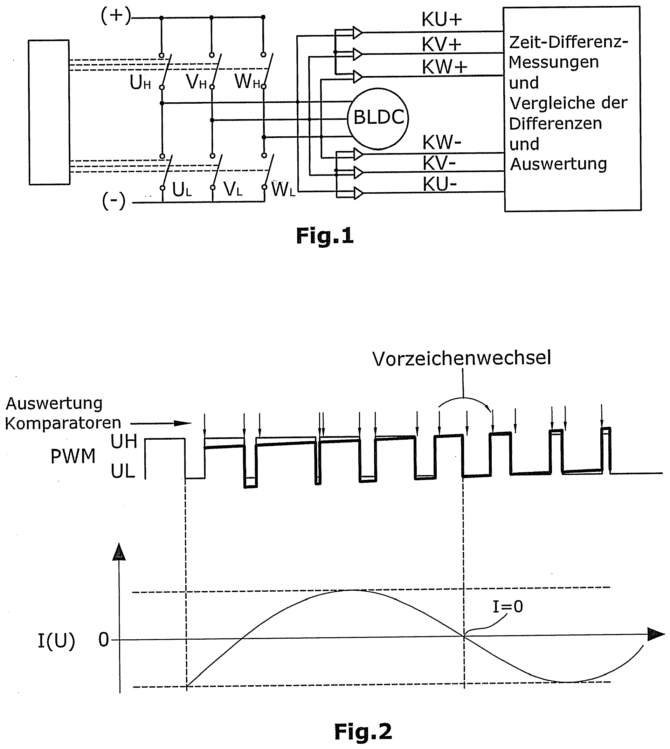

Ein mögliches Beschaltungsschema für einen dreiphasigen Elektromotor mit elektrischer Kommutierung zeigt Fig. 1. Der Motor BLDC wird über eine Treiber-Vollbrücke angesteuert, wobei jeder Motorphase U, V und W ein Schalterpaar, bestehend aus einem Highside-Schalter U_{H}, V_{H} bzw. W_{H} und einem Low-side-Schalter U_{L}, V_{L} bzw. W_{L} zugeordnet ist. Der Spannungsabfall über jedem Schalter wird überwacht, und zwar mittels der Komparatoren KU_{H}, KV_{H}, KW_{H}, KU_{L}, KV_{L} und KW_{L}. Jeder Motorphase U, V und W ist dabei ein Komparator oder ein Paar von Komparatoren zugeordnet. Mit Hilfe dieser Komparatoren ist es möglich festzustellen, wann sich die Richtung des durch einen Schalter fließenden Stroms umkehrt. Damit lässt sich der Nulldurchgang des Stroms durch einen Schalter ermitteln. Konstruktionsbedingt sowie ansteuerungsbedingt liegt der Nulldurchgang innerhalb eines Erwartungswertbereichs (Erwartungszeitfenster). Durch Überprüfung der Zeitpunkte der Nulldurchgänge über mehrere bzw. sämtliche Motorphasen hinweg betrachtet bzw. innerhalb einer Motorphase betrachtet, kann dann auf fehlerhafte Lastbedingungen geschlossen werden. Sofern die naturgemäß von Phase zu Phase oder innerhalb einer Phase abweichenden Nulldurchgangszeitpunkte einem reproduzierbaren Muster folgen, kann dies mit konstruktionsbedingten Asymmetrien des Motors und den nachfolgenden Lasten in Verbindung gebracht werden. Nicht reproduzierbare und insbesondere nicht vorhersehbare Abweichungen der Nulldurchgangszeitpunkte von den Erwartungswertbereichen lassen auf fehlerhafte Lastbedingungen schließen. Derartige Abweichungen sind also als erstes Anzeichen für eine fehlerhafte elektrische oder mechanische Lastbedingung des Motors zu werten.

Fig. 2 zeigt eine Kommutierungsoption für einen mehrphasigen Elektromotor. In diesem Fall ist eine Sinus- bzw. Space-Vector-Kommutierung dargestellt, und zwar innerhalb des Ausschnittes des Kommutierungsverlaufs, in dem der Stromrichtungs-Vorzeichenwechsel in in diesem Beispiel der Phase U stattfindet. Die dünne Kurve in Fig. 2 stellt die theoretische Spannung bei beliebig niederohmiger Ansteuerung der Treiberschalter dar. Die dickere Kurve stellt den Spannungsverlauf unter Berücksichtigung des Spannungsdrops über den betreffenden Treiberschalter dar.

Grundlage der Erfindung ist die Ermittlung von Zeitdifferenzen zwischen jeweils festen Zeitpunkten im Kommutierungsschema und dem jeweils aktuellen Zeitpunkt des Erreichens eines bestimmten Spannungsabfalls über den einzelnen Treibern. Die festen Zeitpunkte sollten zweckmäßigerweise vor einem Nulldurchgang liegen. Ein Sonderfall ist hier das Erreichen des Stroms I=0, was einem Spannungsdrop von 0 Volt gleichkommt. Es kann aber auch jeder andere Stromwert, der während der Kommutierung sicher erreicht wird, als Trägerpunkt für das Ende der Zeitmessung herangezogen werden. Die Ermittlung der Zeitdifferenzen vor dem Erreichen der gewählten Spannungsschwellen in einem Motoranschluss bis zum Erreichen der gleichen Bedingungen im nächsten Motoranschluss ist ebenfalls möglich. In diesem Fall existiert kein fester Startzeitpunkt für die Zeitmessung.

Eine bevorzugte Ausführungsvariante für die Ermittlung der Rezirkulationszeitspanne ist eine logarithmische Zeitmessung. Diese folgt einer einem Logarithmus angenäherten Funktion, und zwar in der Art, dass sich mit zunehmender Zählzeit die Geschwindigkeit des Zählers verringert. Das hat folgende Vorteile:
a) Es können kleine und große Zeiten mit der gleichen relativen Genauigkeit ermittelt werden. Eine unnötig hohe Genauigkeit bei großen Absolutzeitmessungen entfällt.
b) Die Anzahl auszuwertender Bits pro Messwert verringert sich drastisch.
c) Die Ermittlung von Zeitverhältnissen, für die üblicherweise eine "Punktrechnung" notwendig ist, kann wegen der Logarithmusbildung durch eine "Strichrechnung" nachgebildet werden. Dies verringert den Hardware- und Software-Aufwand bei der Vergleichsoperation.
d) Es kann eine kostensparende Umsetzung der Auswertung entweder durch eine kleinere Logik und/oder CPU-zeitsparende Realisierung in einem Controller erfolgen.

## Patentansprüche

1. Verfahren zur Erlangung eines Hinweises auf eine mögliche fehlerhafte Lastbedingung eines mehrphasigen Elektromotors mit elektronischer Kommutierung sowie elektrischer Ansteuersteuerung mit einer Ansteuereinheit, die pro Motorphase einen Highside-Schalter und einen Lowside-Schalter aufweist, wobei die Highside- und Lowside-Schalter der Motorphasen zyklisch geschaltet werden, und zwar gemäß einem Schaltschema, das Zeitpunkte generiert, zu denen der Strom in einer Motorphase einen Nulldurchgang erfährt, der bedingt durch den induktiven Lastanteil des Elektromotors, zeitlich versetzt zu demjenigen Zeitpunkt des Nulldurchganges ist, der bei rein ohmschen Lasten auftreten würde, wobei ohne fehlerhafte Lastbedingung der Zeitpunkt dieses Nulldurchganges in einem Erwartungswertbereich liegt, welcher vom Schaltschema, den Umgebungsbedingungen und von diversen Motorparametern bestimmt wird, wobei bei bestehender fehlerhafter Lastbedingung der Zeitpunkt dieses Nulldurchganges außerhalb des Erwartungswertbereichs liegt, wobei anhand der Abweichung vom Erwartungswertbereich auf die Art der fehlerhaften Lastbedingung geschlossen werden kann, wobei bei dem Verfahren
- während vorgegebener im Schaltschema auftretender Highside- und/oder Lowside-Phasenaufschaltung detektiert wird, ob und wann der Strom durch den eingeschalteten Highside- oder Lowside-Schalter größer oder kleiner als eine vorgebbare Schwelle, im speziellen Fall in der Nähe des Nulldurchganges wird,
- wobei von einem vorgebbaren Zeitpunkt des Schaltschemas an die Zeitspanne, innerhalb derer der durch den eingeschalteten Highside- oder Lowside-Schalter einer der Motorphasen fließende Strom den vorgebbaren Schwellwert über- oder unterschreitet, gemessen wird, wobei sich diese Zeitmessung im Falle einer PWM-Ansteuerung gegebenenfalls über ein oder mehrere PWM-Zyklen erstrecken kann,
- wobei die gemessenen Zeitspannen der einzelnen Motorphasen untereinander verglichen werden und/oder die gemessenen Zeitspannen jeder einzelnen Motorphase für sich zeitlich aufeinanderfolgend miteinander verglichen werden, und
- wobei eine Abweichung der Größe der gemessenen Zeitspannen der einzelnen Motorphasen untereinander und/oder einer Motorphase in sequentieller Abfolge von vorgebbaren Erwartungswertbereichen als ein Hinweis auf eine fehlerhafte Lastbedingung gewertet wird.

2. Verfahren nach Anspruch 1, **dadurch gekennzeichnet, dass** aus der Art der Abweichungen von den Erwartungswertbereichen für die einzelnen Motorphasen untereinander auf die Art der fehlerhaften Lastbedingung wie Nebenschluss Motorphase gegen Motorphase, Nebenschluss Motorphase gegen Masse, Nebenschluss Motorphase gegen Versorgungsspannung, zu hochohmiger Motorphasenanschluss, Wackelkontakt einer Motorphase, fehlerhafte Widerstände einzelner Highside- oder Lowside-Schalter und/oder auch für jede einzelne Motorphase in sequentieller Abfolge auf die fehlerhaften Lastbedingungen wie Wackelkontakt, mechanischer Fehler, Lagerspiel, Getriebefehler, mechanischer Fehler in der Applikation geschlossen wird, wobei die Häufigkeit der sequentiell auftretenden Abweichungen Aussage geben kann über den genauen Fehlerort.

3. Verfahren nach Anspruch 1 oder 2, **dadurch gekennzeichnet, dass** anstelle der Größe eines Stroms ein die Größe des Stroms repräsentierender elektrischer Parameter gemessen wird, und zwar z.B. ein Spannungsabfall über einem elektrischen/elektronischen Bauteil, insbesondere über einem Shunt-Widerstand oder über einem Transistor, bei dem es sich insbesondere um einen Highside- und/oder einen Lowside-Schalter handelt.

4. Verfahren nach einem der Ansprüche 1 bis 3, **dadurch gekennzeichnet, dass** als Stromschwellwert ein Wert ungleich Null des Stroms gewählt wird.

5. Verfahren nach einem der Ansprüche 1 bis 3, **dadurch gekennzeichnet, dass** als Stromschwellwert ein Wert in der Nähe des Nulldurchgangs gewählt wird.

6. Verfahren nach einem der Ansprüche 1 bis 5, **dadurch gekennzeichnet, dass** die Zeitspanne mittels eines linearen Zeitmessglieds mit konstanter Zählgeschwindigkeit gemessen wird.

7. Verfahren nach einem der Ansprüche 1 bis 5, **dadurch gekennzeichnet, dass** die Zeitspanne mittels eines logarithmischen Zeitmessglieds mit mit zunehmender Messzeit ansteigender Zählgeschwindigkeit gemessen wird.

8. Verfahren nach einem der Ansprüche 1 bis 7, **dadurch gekennzeichnet, dass** anstelle der beschriebenen exakten Zeitmessung lediglich zu einem festen Zeitpunkt nach Einschaltung des Highside- und/oder Lowside-Schalters eine Überprüfung auf Über- oder Unterschreitung der vorgebbaren Stromschwelle erfolgt und demzufolge die Zeitmessung in der dadurch entstehenden Auflösung erfolgt.

9. Verfahren nach einem der Ansprüche 1 bis 8, **dadurch gekennzeichnet, dass** anstelle der Zeitspannen zwischen jeweils den besagten Zeitpunkten des Schaltschemas und der Einnahme des Stromschwellwerts diejenige Zeitspanne gemessen wird, innerhalb derer der Strom bei der nächsten Motorphasenaufschaltung wieder den Stromschwellwert erreicht, und dass diese Zeitspannen der einzelnen Motorphasen untereinander und/oder jeder Motorphase für sich in zeitlicher Abfolge verglichen und die Ergebnisse dieser Vergleiche mit für den fehlerfreien Betrieb des Motors geltenden Erwartungswerten verglichen werden, wobei eine Abweichung der Größe der aktuellen Zeitspannen untereinander und/oder von den Erwartungswerten als ein Hinweis auf das Vorliegen eines Fehlerstroms gewertet wird.

10. Verfahren nach einem der Ansprüche 1 bis 9, **dadurch gekennzeichnet, dass** die Erwartungswerte für maximal zulässige Abweichungen, bei denen noch kein fehlerhafter Lastzustand erkannt werden soll, an einem oder mehreren vorgealterten Referenzsystemen mit fehlerfreiem Lastzustand angelernt werden, also die typischen Werte ermittelt und mit wählbaren zusätzlichen zulässigen Toleranzen versehen in der Ansteuereinheit als maximal zulässiger Erwartungswert abgelegt werden.

11. Verfahren nach einem der Ansprüche 1 bis 9, **dadurch gekennzeichnet, dass** die Erwartungswerte für maximal zulässige Abweichungen, bei denen noch kein fehlerhafter Lastzustand erkannt werden soll, an jedem Motorsystem für sich nach der Produktion mit fehlerfreiem Lastzustand angelernt werden, also die typischen Werte ermittelt und mit wählbaren zusätzlichen zulässigen Toleranzen versehen in der Ansteuereinheit als maximal zulässiger Erwartungswert abgelegt werden.

12. Verfahren nach einem der Ansprüche 1 bis 11, **dadurch gekennzeichnet, dass** die Erwartungswerte für maximal zulässige Abweichungen, bei denen noch kein fehlerhafter Lastzustand erkannt werden soll, im Laufe der Lebenszeit des Motors mit höheren Toleranzen versehen werden.

13. Verfahren nach einem der Ansprüche 1 bis 12, **dadurch gekennzeichnet, dass** in dem Fall, dass die detektierte fehlerhafte Lastbedingung durch ein Abweichen des Kommutierungswinkels vom Zielbereich entsteht, die Ansteuereinheit alsdann den Fehler durch Anpassung zumindest eines der beiden Ansteuerparameter Amplitude und Phase kompensiert.

## Claims

1. A method for obtaining an indication of a possible faulty load condition of a multi-phase electric motor with electric commutation and electric drive control having a drive unit which, per motor phase, comprises a high-side switch and a low-side switch, wherein the high-side and low-side switches of the motor phases are cyclically switched according to a switching scheme which generates time points at which the current experiences, in a motor phase, a zero crossing that, owing to the inductive load portion of the electric motor, is temporally shifted relative to that time point of the zero crossing which would occur with purely ohmic loads, wherein, without a faulty load condition, the time point of this zero crossing is within an expected value range which can be determined by the switching scheme, the ambient conditions and by diverse motor parameters, wherein, in case of an existing faulty load condition, the time point of this zero crossing is outside the expected value range, wherein, on the basis of the deviation from the expected value range, a conclusion can be made on the type of the faulty load condition, wherein, in said method,
- during predetermined high-side and/or low-side phase connection occurring in the switching scheme, it is detected whether and when the current through the switched-on high-side or low-side switch becomes greater or smaller than a presettable threshold value which particularly is in the vicinity of the zero crossing,
- wherein, from a presettable time point of the switching scheme, the time interval is measured within which the current flowing through the switched-on high-side or low-side switch of one of the motor phases rises above or falls below the presettable threshold value, wherein, in case of a PWM control, this time measurement can optionally extend over one or a plurality of PWM cycles,
- wherein the measured time intervals of the individual motor phases are compared among each other, and/or the measured time intervals of each individual motor phase in itself are compared, temporally successively, to each other, and
- wherein a deviation, from presettable expected value ranges, of the amount of the measured time intervals in the individual motor phases among each other and/or in one motor phase in sequential order, is evaluated as being an indication of a faulty load condition.

2. The method according to claim 1, **characterized in that**, from the type of the deviations from the expected value ranges for the individual motor phases among each other, conclusions are drawn on the type of the faulty load condition such as e.g. shunt of motor phase toward motor phase, shunt of motor phase toward ground, shunt of motor phase toward supply voltage, too high-ohmic motor phase connection, loose contact of a motor phase, faulty resistances of individual high-side or low-side switches, and/or conclusions are drawn, also for each individual motor phase in sequential order, on faulty load conditions such as e.g. a loose contact, a mechanical defect, play of a bearing, malfunction in the transmission, or a mechanical error in the application, wherein the frequency of the sequentially occurring deviations can allow for a conclusion on the exact site of the malfunction.

3. The method according to claim 1 or 2, **characterized in that**, instead of the amount of a current, there is measured an electrical parameter representing the amount of the current, e.g. a voltage drop across an electric/electronic component, particularly across a shunt resistor or a transistor which particularly is a high-side and/or a low-side switch.

4. The method according to any one of claims 1 to 3, **characterized in that**, as a current threshold value, a value of the current is selected that is not equal to zero.

5. The method according to any one of claims 1 to 3, **characterized in that**, as a current threshold value, a value is selected that is near the zero crossing.

6. The method according to any one of claims 1 to 5, **characterized in that** said time interval is measured by means of a linear time measurement element with constant counting speed.

7. The method according to any one of claims 1 to 5, **characterized in that** said time interval is measured by means of a logarithmic time measurement element having a counting speed increasing with increasing measuring time.

8. The method according to any one of claims 1 to 7, **characterized in that**, instead of the described exact time measurement, there is performed, merely at a fixed time point after switch-on of the high-side and/or low-side switch, an examination for an exceeding or falling-short of the presettable current threshold value and, in accordance therewith, the time measurement is performed in the thus generated resolution.

9. The method according to any one of claims 1 to 8, **characterized in that**, instead of the time intervals respectively between said time points of the switching scheme and the reaching of the current threshold value, there is measured that time interval within which the current, upon the next motor phase being switched on, reaches the current threshold value again, and that these time intervals of the individual motor phases are compared among each other and/or the time intervals of each motor phase for itself are compared in temporal succession, and the results of these comparisons are compared to expectation values valid for fault-free operation of the motor, wherein a deviation of the amount of the present time intervals among each other and/or from the expectation values is evaluated as being an indicator of the existence of a faulty current.

10. The method according to any one of claims 1 to 9, **characterized in that** the expectation values for maximally allowable deviations where it is not yet desired that a faulty load condition is detected, are obtained, by training, on one or a plurality of pre-aged reference systems with fault-free load condition, i.e. the typical values are detected and, provided with selectable additional allowable tolerances, are deposited in the drive unit as a maximum allowable expectation value.

11. The method according to any one of claims 1 to 9, **characterized in that** the expectation values for maximally allowable deviations where it is not yet desired that a faulty load condition is detected, are - after production - obtained, by training, on each motor system for itself with fault-free load condition, i.e. the typical values are detected and, provided with selectable additional allowable tolerances, are deposited in the drive unit as a maximum allowable expectation value range.

12. The method according to any one of claims 1 to 11, **characterized in that** the expectation values for maximally allowable deviations where it is not yet desired that a faulty load condition is detected, are, in the course of the lifetime of the motor, provided with higher tolerances.

13. The method according to any one of claims 1 to 12, **characterized in that**, in case that the detected faulty load condition is generated by deviation of the commutation angle from the target range, the drive unit then compensates for the error by adaptation of at least one of the two drive parameters "amplitude" and "phase".

## Revendications

1. Procédé d'obtention d'une indication sur une condition de charge potentiellement défectueuse d'un moteur électrique multiphasé à commutation électronique à commande d'amorçage électrique dotée d'une unité de commande, laquelle comporte un commutateur côté alimentation et un commutateur côté masse par phase moteur, dans lequel les commutateurs côté alimentation et côté masse des phases moteur sont commutés de manière cyclique, à savoir conformément à un schéma de câblage, lequel génère des instants auxquels le courant dans une phase moteur subit un passage par zéro, lequel est, en fonction de la fraction de charge inductive du moteur électrique, décalé dans le temps par rapport à l'instant du passage par zéro qui serait causé par une charge purement résistive, dans lequel en l'absence de condition de charge défectueuse, l'instant de ce passage par zéro est situé dans un intervalle de valeurs attendues, lequel est déterminé par le schéma de câblage, par les conditions environnantes et par divers paramètres du moteur, dans lequel en présence d'une condition de charge défectueuse l'instant de ce passage par zéro se trouve hors de l'intervalle de valeurs attendues, dans lequel le type de condition de charge défectueuse peut être déduit à l'aide de la déviation par rapport à l'intervalle de valeurs attendues, dans lequel, lors du procédé
- pendant une commutation de phase côté alimentation et/ou côté masse prédéfinie dans le schéma de câblage, il est détecté si et quand le courant traversant le commutateur fermé côté alimentation ou côté masse est supérieur ou inférieur à un seuil pouvant être prédéfini, spécifiquement à proximité du passage à zéro,
- dans lequel la période, à l'intérieur de laquelle le courant traversant le commutateur fermé côté alimentation ou côté masse d'une des phases moteur dépasse ou sous-dépasse la valeur seuil pouvant être prédéfinie, est mesurée à partir d'un instant pouvant être prédéfini du schéma de câblage, dans lequel ce chronométrage peut le cas échéant s'étendre sur un ou plusieurs cycles de modulation de largeur d'impulsion (PWM) dans le cas d'une commande PWM.
- dans lequel les périodes mesurées des phases moteur individuelles sont comparées les unes aux autres et/ou les périodes mesurées de chaque phase moteur individuelle sont comparées l'une à l'autre séparément de manière séquentielle, et
- dans lequel une déviation par rapport à des intervalles de valeurs attendues pouvant être prédéfinis de la grandeur des périodes mesurées des phases moteur individuelles les unes par rapport aux autres et/ou d'une phase moteur en ordre séquentiel est jugée comme une indication sur une condition de charge défectueuse.

2. Procédé selon la revendication 1, **caractérisé en ce qu'**à partir du type des déviations depuis les intervalles de valeurs attendues, le type de condition de charge défectueuse telle que dérivation phase moteur à phase moteur, dérivation phase moteur à masse, dérivation phase moteur à tension d'alimentation, connexion de phase moteur ayant une résistivité trop élevée, mauvais contact d'une phase moteur, résistances défectueuses de commutateurs individuels côté alimentation ou côté masse peut être déduit pour les phases moteur individuelles les unes par rapport aux autres et/ou les conditions de charge défectueuses telles que mauvais contact, défaut mécanique, jeu de palier, défaut de transmission, défaut mécanique dans l'application peuvent être également déduites pour chaque phase moteur individuelle en ordre séquentiel, dans lequel la fréquence des déviations se produisant de façon séquentielle peut donner une indication sur le lieu exact du défaut.

3. Procédé selon la revendication 1 ou 2, **caractérisé en ce qu'**à la place de la grandeur d'un courant, un paramètre électrique représentant la grandeur du courant est mesuré, à savoir par exemple une chute de tension aux bornes d'un composant électrique/électronique, en particulier aux bornes d'une résistance de shunt ou d'un transistor, où il s'agit en particulier d'un commutateur côté alimentation et/ou d'un commutateur côté masse.

4. Procédé selon l'une des revendications 1 à 3, **caractérisé en ce qu'**une valeur du courant différente de zéro est choisie comme valeur seuil de courant.

5. Procédé selon l'une des revendications 1 à 3, **caractérisé en ce qu'**une valeur proche du passage par zéro est choisie comme valeur seuil de courant.

6. Procédé selon l'une des revendications 1 à 5, **caractérisé en ce que** la période est mesurée au moyen d'un instrument de mesure du temps linéaire avec une vitesse de comptage constante.

7. Procédé selon l'une des revendications 1 à 5, **caractérisé en ce que** la période est mesurée au moyen d'un instrument de mesure du temps logarithmique avec une vitesse de comptage augmentant lorsque le temps de mesure s'accroît.

8. Procédé selon l'une des revendications 1 à 7, **caractérisé en ce qu'**à la place du chronométrage exact décrit uniquement jusqu'à un instant fixe après fermeture du commutateur côté alimentation et/ou du commutateur côté masse un contrôle de dépassement ou sous-dépassement du seuil de courant pouvant être prédéfini s'effectue et donc le chronométrage s'effectue dans la résolution qui en découle.

9. Procédé selon l'une des revendications 1 à 8, **caractérisé en ce qu'**à la place des périodes entre les instants respectifs du schéma de câblage et la prise de la valeur seuil de courant, est mesurée la période à l'intérieur de laquelle le courant atteint à nouveau la valeur seuil de courant lors de la commutation de phase moteur suivante, et **en ce que** ces périodes des phases moteur individuelles sont comparées les unes aux autres et/ou chaque phase moteur est comparée séparément en ordre séquentiel et les résultats de ces comparaisons sont comparés aux valeurs attendues valables pour le fonctionnement sans défaut du moteur, dans lequel une déviation de la grandeur des périodes actuelles les unes par rapport aux autres et/ou par rapport aux valeurs attendues est jugée comme une indication sur la présence d'un courant de défaut.

10. Procédé selon l'une des revendications 1 à 9, **caractérisé en ce que** les valeurs attendues pour les déviations maximales autorisées, pour lesquelles aucun état de charge défectueux ne doit être reconnu, sont apprises avec état de charge sans défaut sur un ou plusieurs systèmes de référence pré-vieillis, les valeurs typiques sont donc calculées et sont déposées dans l'unité de commande en tant que valeurs attendues maximales autorisées prévues avec des tolérances autorisées supplémentaires sélectionnables.

11. Procédé selon l'une des revendications 1 à 9, **caractérisé en ce que** les valeurs attendues pour les déviations maximales autorisées, pour lesquelles aucun état de charge défectueux ne doit être reconnu, sont apprises avec état de charge sans défaut séparément sur chaque système moteur après la production, les valeurs typiques sont donc calculées et sont déposées dans l'unité de commande en tant que valeurs attendues maximales autorisées prévues avec des tolérances autorisées supplémentaires sélectionnables.

12. Procédé selon l'une des revendications 1 à 11, **caractérisé en ce que** les valeurs attendues pour les déviations maximales autorisées, pour lesquelles aucun état de charge défectueux ne doit être reconnu, sont prévues avec des tolérances plus élevées au cours de la vie du moteur.

13. Procédé selon l'une des revendications 1 à 12, **caractérisé en ce que** dans le cas où la condition de charge défectueuse détectée apparaît par une déviation de l'angle de commutation par rapport à l'intervalle cible, l'unité de commande compense alors le défaut par adaptation d'au moins un deux paramètres d'amorçage amplitude et phase.
